# EUROPEAN PATENT SPECIFICATION

(11) **EP 4 162 567 B1**
(45) Date of publication and mention of the grant of the patent: **21.08.2024**
(21) Application number: 21731604.1
(22) Date of filing: 01.06.2021
(51) Int. Cl.: H01P 3/12, H01P 3/08, H01P 1/20, H01Q 21/06

(54) **MULTI-LAYER WAVEGUIDE WITH METASURFACE, ARRANGEMENT, AND METHOD FOR PRODUCTION THEREOF**
MEHRSCHICHTIGER WELLENLEITER MIT METAOBERFLÄCHE, ANORDNUNG UND VERFAHREN ZU DESSEN HERSTELLUNG
GUIDE D'ONDES MULTICOUCHE À MÉTASURFACE, DISPOSITION, ET PROCÉDÉ DE PRODUCTION ASSOCIÉ

(30) Priority: 09.06.2020 SE 2050679
(43) Date of publication of application: 12.04.2023
(60) Divisional application: 23159350.0
(73) Proprietor: Gapwaves AB, 412 63 Göteborg (SE)
(72) Inventor: VOSOOGH, Abbas, 417 60 Göteborg (SE)
(74) Representative: Lind Edlund Kenamets Intellectual Property AB
(86) International application number: PCT/SE2021/050506
(87) International publication number: WO 2021/251866

(56) References cited:
- WO-A1-2019/083439
- RU-C1- 2 696 676
- US-A1- 2018 375 185
- US-A1- 2020 185 802
- VOSOOGH ABBAS ET AL: "Novel Air-Filled Waveguide Transmission Line Based on Multilayer Thin Metal Plates", IEEE TRANSACTIONS ON TERAHERTZ SCIENCE AND TECHNOLOGY, IEEE, PISCATAWAY, NJ, USA, vol. 9, no. 3, 1 May 2019 (2019-05-01), pages 282 - 290, XP011723298, ISSN: 2156-342X, [retrieved on 20190507], DOI: 10.1109/TTHZ.2019.2905775

## Description

### Technical field

The present invention relates generally to a multi-layer waveguide transmission line with layers comprising electromagnetic metasurfaces.

### Background art

Waveguides are well known in the art and a common component used to carry electromagnetic waves from a starting point to an endpoint. In its most general term, a waveguide could be a hollow metal pipe.

For waves propagating in open space power is lost over distance reducing both the possible transmission distance and the quality of a wave. Waveguides are therefore a structure adapted to guide waves by restricting the expansion directions of the wave in at least one dimension. The concept is to restrict the wave forcing it to propagate in a specific direction and thereby reducing the losses. In ideal conditions, this would result in the wave losing no power at all, however, this is rarely or never the case. Depending on the waveguide transmission line there is loss and leakage and the waves couple to the edges of the waveguide channels creating energy losses. The concept of waveguides has been known for a long time and is used for transmitting for example signals, sound, or light.

Simultaneously, the use of wireless communication increase and there is a demand from the market for waveguides and antenna arrays based on such technology. The demand from the market further requires compact and inexpensive waveguides.

One available solution is substrate integrated waveguides (SIW) that are compact waveguides based on printed circuit board (PCB) technology and connected top and bottom layers using via holes. Via holes are holes extending between the layers of a waveguide, connecting at least the top and bottom layers. Although cost efficient production methods exist for substrate integrated waveguide the cost increase with increasing frequency due to need for high frequency dielectric.

Another available solution is so called gap waveguide technology. Gap waveguides are generally constructed from two parts where one has pins forming a barrier that prevent propagation of electromagnetic waves in directions other than the intended waveguide direction, thus reducing leakage in such structures. Gap waveguides are suitable for some applications but have limitations in size, typical height of pins is the wavelength divided by 2 to 6, i.e. lambda/2 to lambda/6.

Conventional waveguide assemblies which use metasurfaces are known e.g. from WO 2019/083439 A1, US 2018/375185 A1, RU 2 696 676 C1 and from VOSOOGH ABBAS ET AL: "Novel Air-Filled Waveguide Transmission Line Based on Multilayer Thin Metal Plates", IEEE TRANSACTIONS ON TERAHERTZ SCIENCE AND TECHNOLOGY, IEEE, PISCATAWAY, NJ, USA, vol. 9, no. 3, 1 May 2019, pages 282-290, XP011723298, ISSN: 2156-342X.

### Summary of invention

Although technologies for compact waveguides are available there is a need for compact components, low loss components with good reduction of loss and leakage. SIW, as one example, have an inherent insertion loss that is higher than the corresponding loss of for example air-filled hollow waveguide. Thus, although they provide a cost-efficient alternative there are a need for other solutions. Hollow waveguides generally have other drawbacks, for example the magnetic fields penetrate a short distance into the metal creating leaks that become substantial if there is a gap between two layers, especially if the gap is in the horizontal direction, when making hollow waveguide structure in split-blocks. The reason for this is that the electromagnetic waves are tightly confined and meant to penetrate only a very short distance into the metal.

Dielectric waveguides are another option to reduce leakage however the characteristics of the problem is different for such waveguides due to for example the non-propagating evanescent wave. This is also the reason why such waveguides require high level of conductivity between layers in order to reduce leakage. The high level of conductivity significantly increases the production cost and requires very high accuracy during manufacturing. In addition, the losses are in general still higher than for air-filled waveguide.

Gap waveguides have limitations both in design and size of pin texture making them a useful solution but not applicable for some applications.

A further problem exists in relation to manufacturing of waveguides is that the current level of CNC-milling and molding often provides bad tolerances in the production method compared to other methods such as laser cutting, etching, or chemical etching. This makes it difficult and/or expensive to produce waveguide structures. The problem is more evident for some frequency ranges than for others, for example both CNC-milling and molding are common production methods for waveguides adapted for frequencies below 60 GHz. In higher E-band and D-band frequency range, 71 GHz to 86 GHz and 110 GHz to 170 GHz, the CNC-milling and molding becomes very expensive because everything is very small in relation to how the production technology works. Thereby, it is in some cases not suitable and in some cases not even possible to achieve the desired result.

An object is to provide a new realization of air-filled waveguide transmission line that is easy to produce.

Another object is to provide a waveguide that is cost effective to produce.

Another object is to provide a waveguide that conveniently can be used and design for antenna arrays.

Another object is to provide a waveguide that conveniently can be used to design waveguide filters and diplexers.

Another object is to provide a waveguide that conveniently can be used for active electronic circuits, i.e. power amplifiers (PA), packaging and integration with passive components such as array antennas.

Another object is to provide a multi-layer waveguide with stacked unconnected layers with low leakage.

Another object is to provide a multi-layer waveguide that don't require galvanic contact between the layers to reduce leakage.

Another object of the present invention is to provide a multi-layer waveguide that don't require connectivity between the layers to reduce leakage.

Yet another object of the present invention is to provide a multi-layer waveguide that is compact in comparison to prior art solutions.

It would thus be beneficial with a waveguide that is compact and overcomes at least some of the drawbacks of the prior art.

Thus, the present solution, defined by the appended claims, relates to a cost efficient and easy to produce multi-layer waveguide transmission line with electromagnetic metasurfaces arranged in a specific configuration. The solution is a compact air-filled waveguide with unconnected thin layers stacked together and overcoming many of the drawbacks of prior art solutions. The solution can advantageously be used with metal layers with typical thickness of lambda/10 or lambda/15 and depth of the leak suppressing structure below lambda/20 or even lambda/30. The multi-layer waveguide comprises at least three physical layers assembled into a multi-layer waveguide. The layers are at least one top layer, one or more intermediate layer, and one bottom layer. The multi-layer waveguide further comprises a waveguide channel being an elongated aperture in at least one intermediate layer. At least one layer has a metasurface on a first surface facing a first adjoining layer and the metasurface surrounds the elongated aperture. The metasurface comprise thick and thin sections.

The waveguide channel is in different embodiments arranged with different sizes of elongated apertures in the layers, in some embodiments all layers have different sizes of elongated apertures and in other embodiments some of the layers have corresponding apertures.

The metasurface is a textured surface that have a sub-wavelength thickness, in this particular case, normally below lambda/10. The textured surface comprises thin and thick sections that creates the texture.

It is one advantage that the meta structure in the multi-layer arrangement create a leak reduction effect by the small gap between the layers and the metasurfaces. The effect comes from an electromagnetic band gap but in comparison to previous multi-layer waveguides the metasurface structure has the advantage of being smaller in size and still inexpensive to produce.

According to one embodiment the first surface has a flat portion surrounding the metasurface. The thick sections have a thickness corresponding to the layer thickness at the flat portion and the thin sections have a thickness that is less than the thickness at the flat portion.

According to one embodiment, a second surface of the intermediate layer is facing a second adjoining layer that has a flat surface except for the elongated aperture.

The metasurface faces a flat surface creating small air-filled spaces between the surfaces of the layers creating an electromagnetic band gap structure.

According to one embodiment, the layers are stacked separate layers without elements extending between the layers.

It is one advantage with the present solution that a small gap is acceptable between all or some of the layers without increasing leakage.

According to one embodiment, each thick section has any one of a circular, elliptical, triangular, square, pentagonal, rectangular, rectangular, square, hexagonal, or rectangular shape.

It is one advantage that the shape of the thick sections could vary between different layers or different waveguides.

According to one embodiment the thick sections are arranged in rows parallel to the elongated aperture.

According to one embodiment the thick sections are arranged at irregular distances from the elongated aperture.

According to one embodiment the thick sections are arranged in a random pattern surrounding the elongated aperture.

According to one embodiment the metasurface surrounds the elongated aperture.

According to one embodiment, the multi-layer waveguide comprises a first, second, and third intermediate layer each comprises an elongated aperture, and the second intermediate layer further comprises a central member arranged within the elongated aperture.

In different embodiments all or some layers have metasurfaces. In one embodiment only intermediate layers have metasurfaces, in another embodiment at least one of the top and bottom layers have a metasurface. The metasurfaces are in one embodiment arranged to face a flat surface of an adjoining layer, i.e. two metasurfaces don't face each other in such an embodiment.

According to one embodiment, the multi-layer waveguide comprises a first, second, and third intermediate layer wherein the second intermediate layer is a non-textured layer for integrated electronic chipsets.

It is one advantage that a non-textured layer, i.e. a layer without a metasurface could be used for integrating electronic chipsets.

According to one embodiment, the difference in thickness between the thick sections and the thin sections of the metasurface is less than the wavelength divided by 10.

According to one embodiment, the difference in thickness between the thick sections and the thin sections of the metasurface is less than the wavelength divided by 20.

According to one embodiment, the difference in thickness between the thick sections and the thin sections of the metasurface is less than the wavelength divided by 30.

It is one advantage with the present solution that the metasurface enables waveguides that are smaller in size comparing to other available alternatives without increasing the leakage. It is another advantage that the multi-layer structure in combination with the metasurfaces that leakage between the layers is significantly reduced. Although larger metasurface is a possibility it is one clear advantage that smaller metasurfaces are easier to produced than alternatives for corresponding frequencies.

According to one aspect, a method for producing a multi-layer waveguide as described herein is disclosed.

According to an embodiment the metasurface of different layers in the multi-layer waveguide has an asymmetric configuration.

It is one advantage of the present solution that the metasurfaces of each layer in the multi-layer waveguide that has a metasurface don't have to be identical. The metasurfaces could for example be arranged with thick and thin sections aligning with each other between layers or arranged in an asymmetric configuration wherein the thin and thick sections don't align.

According to an embodiment the thin and thick sections are arranged periodically along a perimeter outside the elongated aperture of each layer.

According to one embodiment the metasurface is not identical on each layer.

According to an embodiment the central member of an elongated aperture is connected to the rest of the layer with one connection tab spanning the aperture, wherein the connection tab is an integrated part of the layer.

According to an embodiment the distance between the layers of the multi-layer waveguide is between 0 and 20 microns.

According to an embodiment the distance between the layers of the multi-layer waveguide is between 0 and 50 microns.

According to an embodiment the multi-layer waveguide is a transmission line implemented as any one of an antenna, an antenna array, and a filter.

It is one advantage with the present solution that the multi-layer waveguide can be implemented as for example a slotted waveguide antenna.

It is another advantage with the present solution that the multi-layer waveguide can be implemented for chipset packaging, such as packaging of MMIC (Monolithic Microwave Integrated Circuit).

According to an embodiment the waveguide is made from one single material.

According to an embodiment the multi-layer waveguide is made from layers of a single material coated with a metal.

According to an embodiment the multi-layer waveguide is assembled with a non-conductive adhesive.

According to an embodiment the layers are directly stacked.

According to an embodiment the layers are stacked unconnected thin layers.

It is one advantage that the multi-layer waveguide doesn't require any galvanic, electric, or physical connection between the layers. I.e. a small gap can exist between the layers. This gap could for example be an uncontrolled air gap from production of the layers. The gap could also be on micron or even an atomic level.

According to an embodiment the layers are stacked unconnected thin metal layers.

According to an embodiment the layers of the multi-layer waveguide is held together with any one of a conductive glue, an isolating glue, and two screws.

It is one advantage with the present solution that any form of bonding or attachment means can be used to hold the layers together. The reason for this is that no electric conductivity is required between the layers in order to suppress leakage. However, it shall be noted that conductivity won't affect the performance in a negative way. I.e. the multi-layer waveguide according to the solution as described herein works well regardless of the conductive properties between the layers.

### Brief description of drawings

The invention is now described, by way of example, with reference to the accompanying drawings, in which:
Fig. 1 illustrates one embodiment of a multi-layer waveguide with layers comprising a metasurface, wherein the top layer is presented as an exploded view.
Fig. 2 illustrates one embodiment of an isometric cross-section of an intermediate layer.
Fig. 3 illustrates an exploded view of one embodiment of a multi-layer waveguide with layers comprising a metasurface.
Fig. 4 illustrates a cross-section of an embodiment as illustrated in figure 3.
Fig. 5 illustrates a cross-section of part of an intermediate layer where thin and thick sections of a metasurface is illustrated in detail.
Fig. 6 illustrates a cross-section showing one embodiment of metasurfaces in multiple layers wherein the metasurface is produced using chemical etching as the fabrication method.
Fig. 7 illustrates one embodiment showing a co-axial multi-layer waveguide with metasurfaces in multiple layers.
Fig. 8 illustrates a cross-section of one embodiment of a co-axial multi-layer waveguide with a flat layer between multiple layers with metasurfaces.
Fig. 9 illustrates a cross-section of one embodiment of a rectangular multi-layer waveguide with metasurfaces in a bottom layer.
Fig. 10 illustrates one embodiment wherein the metasurface section have a round shape.
Fig. 11 illustrates one embodiment wherein the thick and/or thin sections are unevenly arranged in the metasurface.
Fig. 12 illustrates one embodiment wherein multiple waveguides are arranged as slotted waveguide antennas in one unit.
Fig. 13 illustrates a bottom view of a top layer according to the embodiment as illustrated in Fig. 12.
Fig. 14 illustrates one embodiment of a multi-layer waveguide arranged as a slotted waveguide antenna.
Fig. 15 illustrates one embodiment of a multi-layer waveguide arranged as a slotted waveguide antenna, wherein corrugations to reduce unwanted signal propagations are arranged in the extension direction of the waveguide channel.

### Description of embodiments

In the following, a detailed description of the different embodiments of the invention is disclosed under reference to the accompanying drawings. All examples herein should be seen as part of the general description and are therefore possible to combine in any way of general terms. Individual features of the various embodiments and aspects may be combined or exchanged unless such combination or exchange is clearly contradictory to the overall function of the multi-layer waveguide, arrangement, or production method thereof.

Briefly described the solution relates to a compact multi-layer waveguide without any requirement for electrical and galvanic contact between the layers. The multi-layer waveguide has metasurfaces in layers arranged as leak suppressing structure for reducing energy leakage between the layers of the waveguide. The metasurface comprise multiple thick and thin sections surrounding a waveguide channel.

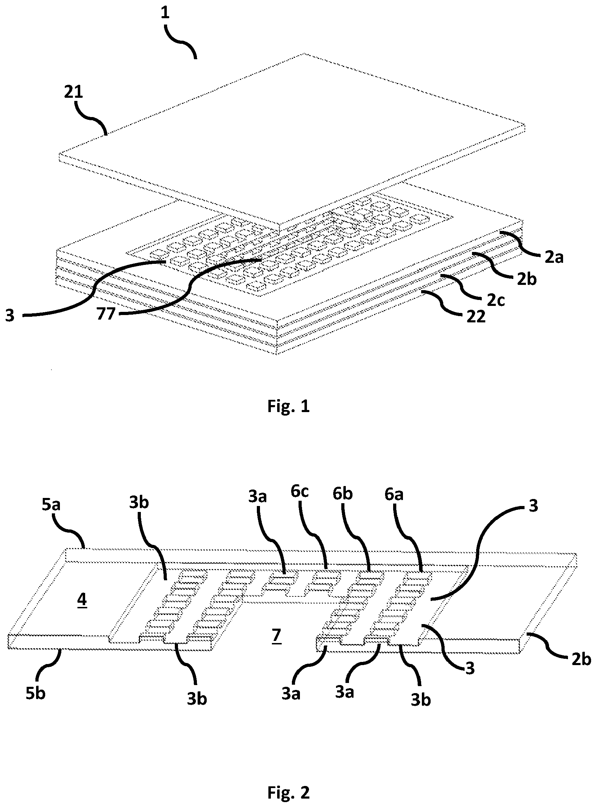

Figure 1 illustrates one embodiment of a multi-layer waveguide 1 with multiple layers 21, 2a, 2b, 2c, 22 of a multi-layer waveguide. The intermediate layers 2a, 2b, 2c, 2d, 2e each has an elongated aperture 7 that alone or together with elongated apertures of other layers creates a waveguide channel 77. The elongated aperture 7 is in some or all of the intermediate layers surrounded by a metasurface.

Figure 2 illustrates a cross-section of part of an intermediate layer 2b. The layer comprises an elongated aperture 7 which off only part is visible in the illustration of figure 2. The elongated aperture 7 is surrounded by a metasurface 3 comprising thick 3a and thin 3b sections. The thick 3a and thin 3b sections together creates the metasurface, wherein the metasurface is leak suppressing in the way that it helps guide the wave and keep it within the waveguide channel 77 that the elongated aperture 7 is part of.

Figure 2 further illustrates a flat portion 4 surrounding the metasurface 3. The flat portion 4, in one embodiment has the same thickness as the thick sections 3a. In the embodiment as illustrated in figure 2 the thick sections 3a are arranged in straight rows 6a, 6b, 6c. In one embodiment the number of straight rows 6a, 6b, 6c could be one, two, three or more at any or all sides of the elongated aperture 7.

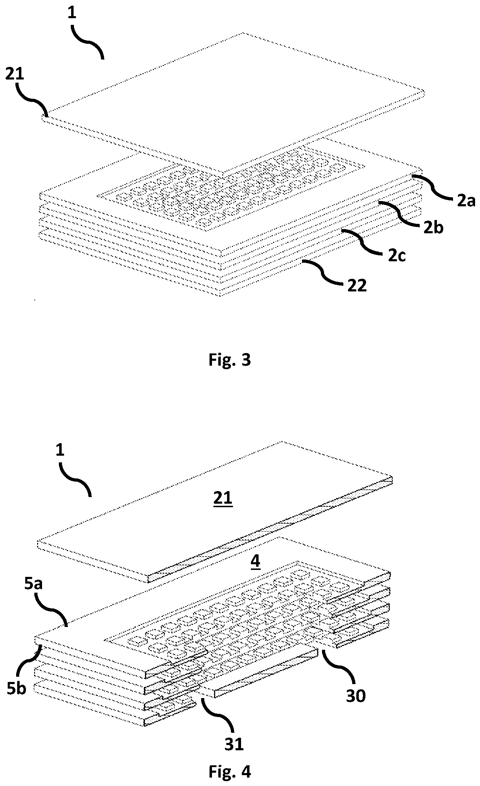

Figure 3 illustrates one embodiment of the multi-layer waveguide 1 wherein the layers are spaced apparat. This exploded view illustrates an important feature of the multi-layer waveguide 1 in that no galvanic, electric, or physical connection is required between the layers. I.e. a small gap can exist between the layers. This gap could for example be an uncontrolled air gap from production of the layers. The gap could also be on micron or even an atomic level. However, it shall be noted that the size of the gap as illustrated in figure 3 is only for illustration, the gap between the layers could typically be anywhere between 0 and 15 micrometers.

Figure 4 illustrates a cross-section of one embodiment of a multi-layer waveguide 1 wherein the entry 30 and exit 31 openings are visible. Those openings 30, 31 are the openings wherein the wave enter and exits the waveguide channel 77. Figure 4 further illustrates a first 5a and second 5b surface identified for one intermediate layer 2b. It shall be noted that each layer comprises a first 5a and second 5b surface. The entry 30 and exit 31 openings don't have to be arranged in the bottom layer 22. In another embodiment the entry 30 and exit 31 openings are instead arranged in the top layer 21. In yet another embodiment the entry 30 and exit 31 openings are arranged in different layers, for example, the entry opening 30 could be arranged in the top layer 21 and the exit opening 31 in the bottom layer 22, or vice versa.

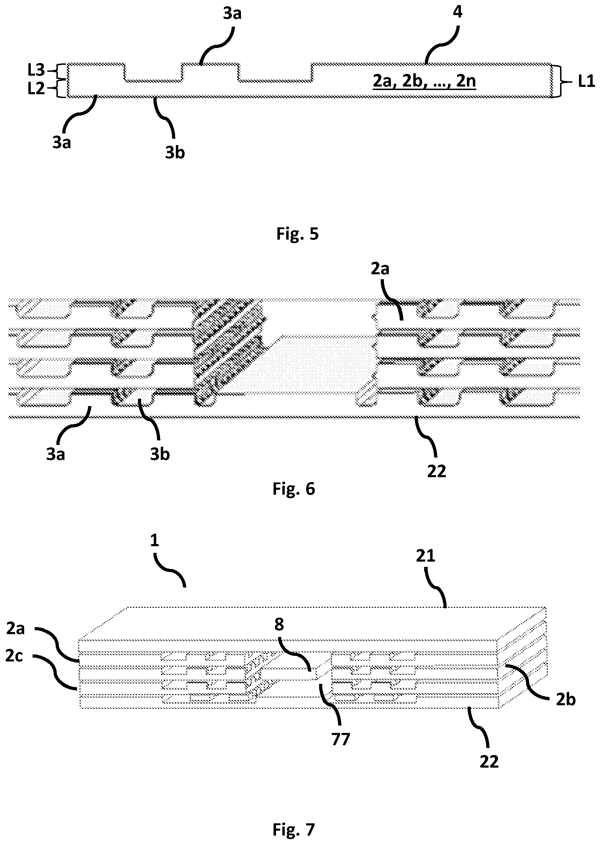

Figure 5 illustrates parts of an intermediate layer 2a, 2b, ..., 2n or part of a top 21 or bottom 22 layer with a metasurface 3. Figure 5 illustrates differences in thickness between the thick 3a and thin 3b sections as well as the flat portion 4. The difference can for example be between 50-70%, 50-60%, 55-65%, or 60-70% of the total thickness of the layer, however the difference in thickness might vary also outside said range.

Figure 6 illustrates one embodiment of the metasurfaces 3 wherein the metasurface 3 was produced by metal chemical etching creating a characteristic shape of the edges in the metasurface, the shape of the edges in the metasurface becomes rounded. It shall be noted that other production methods such as CNC, laser cutting etc. also are possible.

Figure 7 illustrates a co-axial multi-layer waveguide 1 wherein the waveguide channel 77 comprises a central member 8 arranged within the elongated aperture 7 of one intermediate layer 2a, 2b, 2c, ..., 2n. The center member 8 is attached to the rest of the layer at one or more place connecting the central member to the layer and keeping it in place.

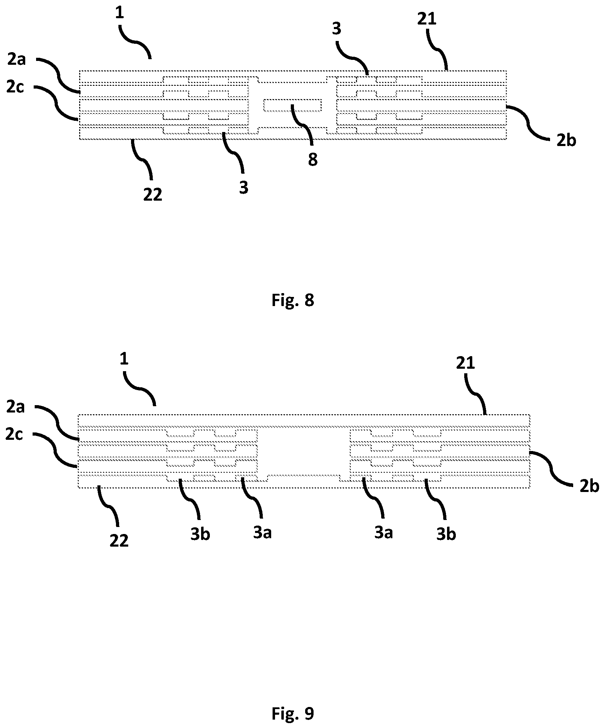

Figure 8 illustrates one embodiment of a co-axial multi-layer waveguide 1 wherein the top 21 and bottom 22 layers have metasurfaces 3. It shall be noted that the top 21 and bottom 22 layers in some embodiments have metasurfaces 3 and in some they don't. Further, in some embodiment, as illustrated in for example figure 8, one or more intermediate layer doesn't have a metasurface 3.

Figure 9 illustrates another embodiment of a multi-layer waveguide 1 wherein the top layer 21 don't have any metasurface but the intermediate layers 2a, 2b, 2c and the bottom layer 22 have metasurfaces.

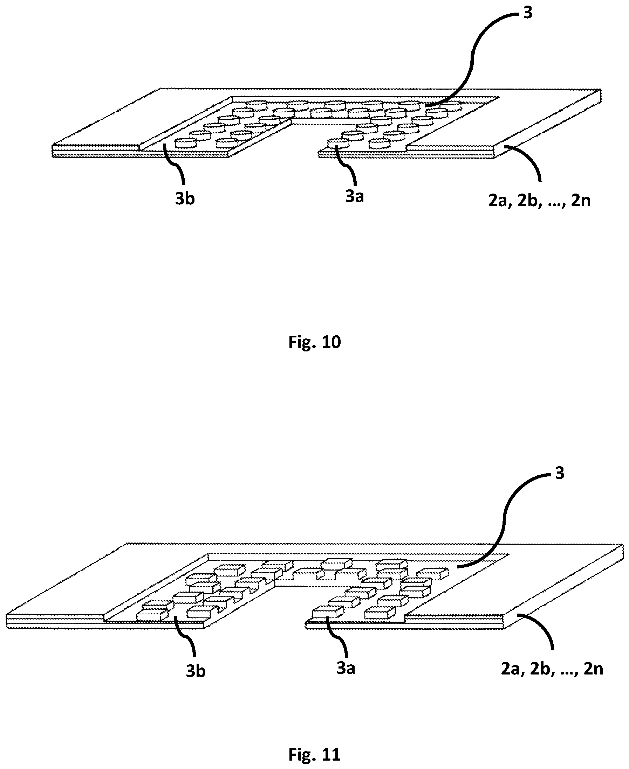

Figure 10 illustrates one embodiment of an intermediate layer 2a, 2b, 2c, ..., 2n, wherein the thick sections 3a have a round shape. It shall be noted that the shape is not important to the functionality and the metasurface 3 may have thick sections 3a of many different shapes, both in the same and in different metasurfaces 3.

Figure 11 illustrates another embodiment wherein the thick sections 3a of the metasurface 3 are randomly placed around the elongated aperture 7. Figure 11 is a representation of how the thick sections 3a could be arranged but it shall be noted that describes herein is only different possible embodiments and other arrangements of the thick sections 3a is also possible within the scope of the claims. The small gap between the layers and the metasurface provide the electromagnetic bandgap (EBG) structure.

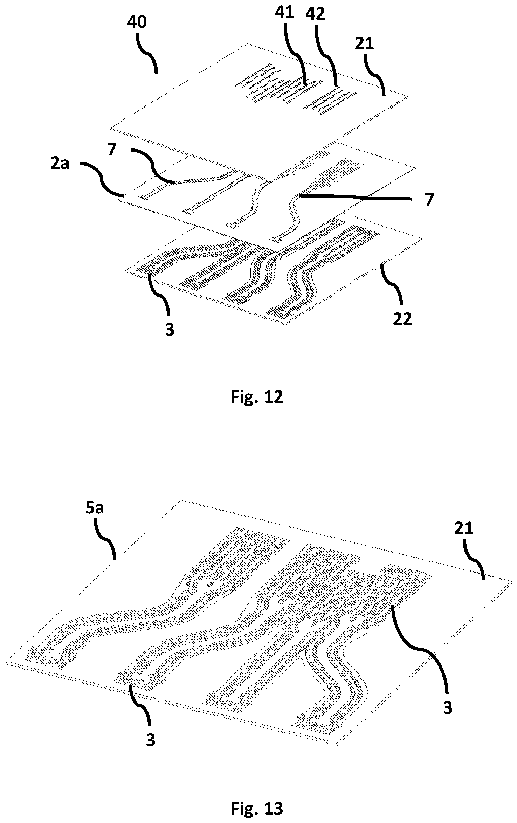

Figure 12 illustrates an exploded isometric view of a multi-layer slotted waveguide antenna 40 as one implementation of waveguides 1 as described herein. The embodiment as illustrated in figure 12 shows a top layer 21, an intermediate layer 2a, and a bottom layer 22. The top layer 21 comprise antenna slots 41 and corrugations 42 arranged at one end of the waveguide 1. The intermediate layer 2a comprise elongated apertures 7 providing routing in each waveguide 1. The bottom 22 and the top layer 21 comprise meta surfaces 3 arranged to surround the elongated apertures 7 of the intermediate layer 2a.

The elongated apertures 7 as illustrated in Figure 12 comprise support structures for enhancing the mechanical support of the layer. The support structures are arranged within the elongated apertures 7 providing an embodiment wherein multiple elongated apertures 7 are arranged instead of a single aperture extending the entire length. In one embodiment this is merely for structural support.

Figure 13 illustrates a bottom view of the top layer 21 as illustrated in Figure 12. As shown, the top layer 21 in one embodiment comprises meta surfaces 3 arranged to surround the elongated apertures 7 of the intermediate layer 2a. As understood, the embodiments as illustrated in figures 12 and 13 are merely examples of how the solution as described herein could be implemented as a slotted waveguide antenna 40. Figure 12 and 13 further illustrates how the routing of the waveguide 1 may differ depending of the implementation. For example, the routing may in one embodiment be straight and in another comprise one or more turns.

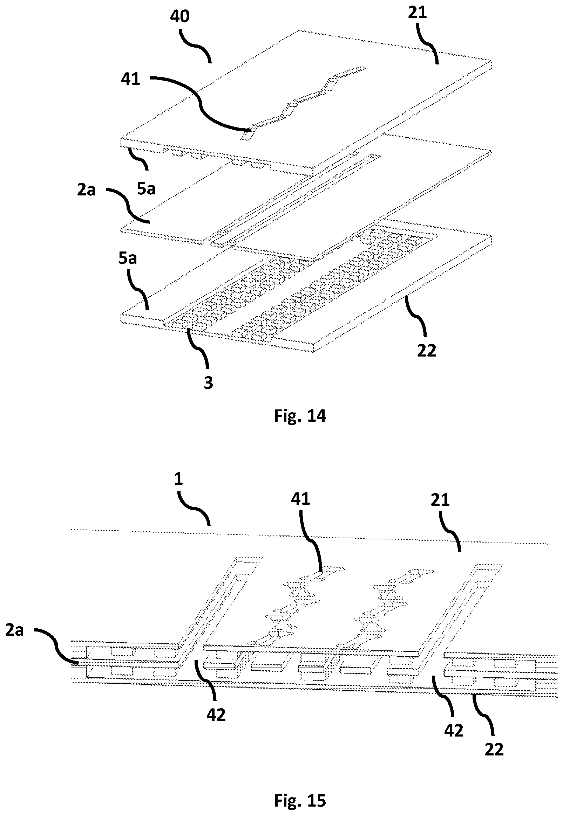

Figure 14 illustrate one embodiment of a multi-layer waveguide 1 implemented as a slotted waveguide antenna 40. Figure 15 illustrate a slightly more complex multi-layer waveguide 1 implemented as a slotted waveguide antenna 40 wherein corrugations 42 are arranged to reduce ripple in the transmission pattern. The corrugations 42 reduce surface currents in the top layer and thus enhance the propagation pattern. As illustrated in Figure 14 the corrugations 42 extend through the top 21 and intermediate layer 2a. In another embodiment wherein the multi-layer waveguide implemented as a slotted waveguide antenna 40 comprise additional intermediate layers 2b, 2c, ..., 2n, the corrugations 42 extends through the top layer 21 and the intermediate layers 2a, 2b, 2c, ..., 2n. In yet another embodiment the corrugations 42 extend through at least the top layer 21 and at least some of the intermediate layers 2a, 2b, 2c, ..., 2n.

## Claims

1. A multi-layer waveguide (1) comprising at least three physical metal layers (21,2a, 2b, 2c, ..., 2n, 22) assembled into said multi-layer waveguide (1), wherein the physical layers are a top layer (21), one or more intermediate layers (2a, 2b, ..., 2n), and a bottom layer (22), the multi-layer waveguide (1) comprises a waveguide channel (77) being an elongated aperture (7) in at least one of said intermediate layers (2a, 2b, ..., 2n), wherein respective intermediate layer (2a, 2b, ..., 2n) of said physical layers (21,2a, 2b, ..., 2n, 22) has a metasurface (3) on a first surface (5a) facing a first adjoining layer, wherein the metasurface (3) surrounds the elongated aperture (7) and is a textured surface, having a sub-wavelength thickness below wavelength divided by 10, created by thick (3a) and thin (3b) sections.

2. A multi-layer waveguide (1) comprising at least three physical layers (21, 2a, 2b, 2c, ..., 2n, 22) assembled into said multi-layer waveguide (1), wherein the physical layers are a top layer (21), one or more intermediate layer (2a, 2b, ..., 2n), and a bottom layer (22), the multi-layer waveguide (1) comprises a waveguide channel (77) being an elongated aperture (7) in at least one of said intermediate layers (2a, 2b, ..., 2n), wherein at least one of said physical layers (21, 2a, 2b, ..., 2n, 22) has a metasurface (3) on a first surface (5a) facing a first adjoining layer, wherein the metasurface (3) surrounds the elongated aperture (7) and is a textured surface, having a sub-wavelength thickness below wavelength divided by 10, created by thick (3a) and thin (3b) sections;
wherein the multi-layer waveguide comprises first (2a), second (2b), and third (2c) intermediate layers wherein the second intermediate layer (2b) is a non textured layer for integrated electronic chipsets;
OR
wherein the multi-layer waveguide comprises a first (2a), second (2b), and third (2c) intermediate layers, each comprising an elongated aperture (7), and wherein the second intermediate layer (2b) is a non-textured layer and further comprises a central member (8) arranged within the elongated aperture (7).

3. A multi-layer waveguide (1) comprising at least three physical layers (21, 2a, 2b, 2c, ..., 2n, 22) assembled into said multi-layer waveguide (1), wherein the physical layers are a top layer (21), one or more intermediate layers (2a, 2b, ..., 2n), and a bottom layer (22), the multi-layer waveguide (1) comprises a waveguide channel (77) being an elongated aperture (7) in at least one of said intermediate layers (2a, 2b, ..., 2n), wherein respective intermediate layer (2a, 2b, ..., 2n) of said physical layers (21, 2a, 2b, ..., 2n, 22) has a metasurface (3) on a first surface (5a) facing a first adjoining layer, wherein the metasurface (3) surrounds the elongated aperture (7) and is a textured surface, having a sub-wavelength thickness below wavelength divided by 10, created by thick (3a) and thin (3b) sections, wherein the multi-layer waveguide is made from one single material or the multi-layer waveguide is made from layers of a single material coated with a metal.

4. The multi-layer waveguide (1) according to any one of claims 1-3, wherein the first surface (5a) has a flat portion (4) surrounding the metasurface (3), and wherein the thick sections (3a) have a thickness corresponding to the layer thickness (L1) at the flat portion (4) and the thin sections (3b) have a thickness (L2) that is less than the thickness at the flat portion (4).

5. The multi-layer waveguide (1) according to any one of claims 1-4, wherein a second surface (5b) of the layer (21, 2a, 2b, ..., 2n, 22) facing a second adjoining layer is a flat surface except for the elongated aperture (7).

6. The multi-layer waveguide (1) according to any one of claims 1-5 wherein said at least three physical layers (21, 2a, 2b, 2c, ..., 2n, 22) are stacked separate layers without elements extending between any of said at least three physical layers (21, 2a, 2b, 2c, ..., 2n, 22).

7. The multi-layer waveguide (1) according to any one of claims 1-6, wherein each thick section (3a) has any one of a circular, elliptical, triangular, square, pentagonal, rectangular, rectangular, square, hexagonal, or rectangular shape.

8. The multi-layer waveguide (1) according to any one of claims 1-7,
wherein the thick sections (3a) are arranged in rows (6a, 6b, 6c, ..., 6n) parallel to the elongated aperture (7).

9. The multi-layer waveguide (1) according to any one of claims 1 -7,
wherein the thick sections (3a) are arranged at irregular distances from the elongated aperture (7).

10. The multi-layer waveguide (1) according to any one of claims 1-9,
wherein the difference in thickness (L3) between the thick sections (3a) and the thin sections (3b) of the metesurface (3) is between 50-70% of the total thickness of said at least one physical layer that has the metasurface (3).

11. The multi-layer waveguide (1) according to any one of claims 1-10,
wherein the difference in thickness (L3) between the thick sections (3a) and the thin sections (3b) of the metasurface (3) is less than the wavelength divided by 10.

12. The multi-layer waveguide (1 ) according to any one of claims 1 - 11, wherein the difference in thickness (L3) between the thick sections (3a) and the thin sections (3b) of the metasurface (3) is less than the wavelength divided by 20, preferably less than the wavelength divided by 25.

13. The multi-layer waveguide (1) according to any one of claims 1-12,
wherein any one of the top (21) and bottom (22) layers comprises a metasurface (3).

14. The multi-layer waveguide (1) according to any one of claims 1-13, wherein the multi-layer waveguide (1) is implemented as a slotted waveguide antenna (40).

15. The multi-layer waveguide (1) according to any one of claims 1-14, wherein the top layer (21) comprises antenna slots (41).

16. A method for producing a multi-layer waveguide (1) according to any one of claims 1-15.

## Patentansprüche

1. Mehrschichtiger Wellenleiter (1), aufweisend mindestens drei physische Metallschichten (21, 2a, 2b, 2c, ..., 2n, 22), die in dem mehrschichtigen Wellenleiter (1) montiert sind, wobei die physischen Schichten eine obere Schicht (21), eine oder mehrere Zwischenschichten (2a, 2b, ..., 2n) und eine untere Schicht (22) sind, wobei der mehrschichtige Wellenleiter (1) einen Wellenleiterkanal (77) aufweist, der eine langgestreckte Öffnung (7) in mindestens einer der Zwischenschichten (2a, 2b, ..., 2n) ist, wobei die jeweilige Zwischenschicht (2a, 2b, ..., 2n) der physischen Schichten (21, 2a, 2b, ..., 2n, 22) eine Metaoberfläche (3) auf einer ersten Fläche (5a) aufweist, die einer ersten angrenzenden Schicht gegenüberliegt, wobei die Metaoberfläche (3) die langgestreckte Öffnung (7) umschließt und eine texturierte Fläche ist, die eine Sub-Wellenlängen-Dicke aufweist, die geringer ist als die Wellenlänge geteilt durch 10, und durch dicke (3a) und dünne (3b) Abschnitte erzeugt wird.

2. Mehrschichtiger Wellenleiter (1), aufweisend mindestens drei physische Schichten (21, 2a, 2b, 2c, ..., 2n, 22), die in dem mehrschichtigen Wellenleiter (1) montiert sind, wobei die physischen Schichten eine obere Schicht (21), eine oder mehrere Zwischenschichten (2a, 2b, ..., 2n) und eine untere Schicht (22) sind, wobei der mehrschichtige Wellenleiter (1) einen Wellenleiterkanal (77) aufweist, der eine langgestreckte Öffnung (7) in mindestens einer der Zwischenschichten (21, 2a, 2b, ..., 2n) ist, wobei mindestens eine der physischen Schichten (2a, 2b, ..., 2n, 22) eine Metaoberfläche (3) auf einer ersten Fläche (5a) aufweist, die einer ersten angrenzenden Schicht gegenüberliegt, wobei die Metaoberfläche (3) die langgestreckte Öffnung (7) umschließt und eine texturierte Fläche ist, die eine Sub-Wellenlängen-Dicke aufweist, die geringer ist als die Wellenlänge geteilt durch 10, und durch dicke (3a) und dünne (3b) Abschnitte erzeugt wird;
wobei der mehrschichtige Wellenleiter erste (2a), zweite (2b) und dritte (2c) Zwischenschichten aufweist, wobei die zweite Zwischenschicht (2b) eine nicht texturierte Schicht für einen integrierten elektronischen Chipsatz ist;
ODER
wobei der mehrschichtige Wellenleiter eine erste (2a), zweite (2b) und dritte (2c) Zwischenschicht aufweist, die jeweils eine langgestreckte Öffnung (7) aufweisen, und wobei die zweite Zwischenschicht (2b) eine nichttexturierte Schicht ist und ferner ein zentrales Element (8) aufweist, das innerhalb der langgestreckten Öffnung (7) angeordnet ist.

3. Mehrschichtiger Wellenleiter (1), aufweisend mindestens drei physische Schichten (21, 2a, 2b, 2c, ..., 2n, 22), die in dem mehrschichtigen Wellenleiter (1) montiert sind, wobei die physischen Schichten eine obere Schicht (21), eine oder mehrere Zwischenschichten (2a, 2b, ..., 2n) und eine untere Schicht (22) sind, wobei der mehrschichtige Wellenleiter (1) einen Wellenleiterkanal (77) aufweist, der eine langgestreckte Öffnung (7) in mindestens einer der Zwischenschichten (2a, 2b, ..., 2n) ist, wobei die jeweilige Zwischenschicht (2a, 2b, ..., 2n) der physischen Schichten (21, 2a, 2b, ..., 2n, 22) eine Metaoberfläche (3) auf einer ersten Fläche (5a) aufweist, die einer ersten angrenzenden Schicht gegenüberliegt, wobei die Metaoberfläche (3) die langgestreckte Öffnung (7) umschließt und eine texturierte Fläche ist, die eine Sub-Wellenlängen-Dicke aufweist, die geringer ist als die Wellenlänge geteilt durch 10, und durch dicke (3a) und dünne (3b) Abschnitte erzeugt wird, wobei der mehrschichtige Wellenleiter aus einem einzigen Material hergestellt ist oder der mehrschichtige Wellenleiter aus Schichten aus einem einzigen Material hergestellt ist, die mit einem Metall beschichtet sind.

4. Mehrschichtiger Wellenleiter (1) nach einem der Ansprüche 1 bis 3, wobei die erste Fläche (5a) einen flachen Abschnitt (4) aufweist, der die Metaoberfläche (3) umschließt, und wobei die dicken Abschnitte (3a) eine Dicke aufweisen, die der Schichtdicke (L1) an dem flachen Abschnitt (4) entspricht und die dünnen Abschnitte (3b) eine Dicke (L2) aufweisen, die geringer ist als die Dicke an dem flachen Abschnitt (4).

5. Mehrschichtiger Wellenleiter (1) nach einem der Ansprüche 1 bis 4, wobei eine zweite Fläche (5b) der Schicht (21, 2a, 2b, ... , 2n, 22), die einer zweiten angrenzenden Schicht gegenüberliegt, mit Ausnahme der langgestreckten Öffnung (7) eine flache Fläche ist.

6. Mehrschichtiger Wellenleiter (1) nach einem der Ansprüche 1 bis 5, wobei die mindestens drei physischen Schichten (21, 2a, 2b, 2c, ... , 2n, 22) gestapelte separate Schichten ohne Elemente sind, die sich zwischen irgendwelchen der mindestens drei physischen Schichten (21, 2a, 2b, 2c, ... , 2n, 22) erstrecken.

7. Mehrschichtiger Wellenleiter (1) nach einem der Ansprüche 1 bis 6, wobei jeder dicke Abschnitt (3a) eine beliebige aus einer runden, elliptischen, dreieckigen, quadratischen, fünfeckigen, rechteckigen, rechteckigen, quadratischen, sechseckigen oder rechteckigen Form aufweist.

8. Mehrschichtiger Wellenleiter (1) nach einem der Ansprüche 1 bis 7, wobei die dicken Abschnitte (3a) in Reihen (6a, 6b, 6c, ..., 6n) parallel zu der langgestreckten Öffnung (7) angeordnet sind.

9. Mehrschichtiger Wellenleiter (1) nach einem der Ansprüche 1 bis 7, wobei die dicken Abschnitte (3a) in unregelmäßigen Entfernungen von der langgestreckten Öffnung angeordnet sind (7).

10. Mehrschichtiger Wellenleiter (1) nach einem der Ansprüche 1 bis 9, wobei die Differenz der Dicke (L3) zwischen den dicken Abschnitten (3a) und den dünnen Abschnitten (3b) der Metaoberfläche (3) zwischen 50-70 % der gesamten Dicke der mindestens einen physischen Schicht ist, die die Metaoberfläche (3) aufweist.

11. Mehrschichtiger Wellenleiter (1) nach einem der Ansprüche 1 bis 10, wobei die Differenz der Dicke (L3) zwischen den dicken Abschnitten (3a) und den dünnen Abschnitten (3b) der Metaoberfläche (3) geringer als die Wellenlänge geteilt durch 10 ist.

12. Mehrschichtiger Wellenleiter (1) nach einem der Ansprüche 1 bis 11, wobei die Differenz der Dicke (L3) zwischen den dicken Abschnitten (3a) und den dünnen Abschnitten (3b) der Metaoberfläche (3) geringer als die Wellenlänge geteilt durch 20 ist, bevorzugt geringer als die Wellenlänge geteilt durch 25.

13. Mehrschichtiger Wellenleiter (1) nach einem der Ansprüche 1 bis 12, wobei entweder die obere (21) oder die untere (22) Schicht eine Metaoberfläche (3) aufweist.

14. Mehrschichtiger Wellenleiter (1) nach einem der Ansprüche 1 bis 13, wobei der mehrschichtige Wellenleiter (1) als eine schlitzförmige Wellenleiterantenne (40) umgesetzt ist.

15. Mehrschichtiger Wellenleiter (1) nach einem der Ansprüche 1 bis 14, wobei die obere Schicht (21) Antennenschlitze (41) aufweist.

16. Verfahren zum Herstellen eines mehrschichtigen Wellenleiters (1) nach einem der Ansprüche 1 bis 15.

## Revendications

1. Guide d'ondes multicouches (1) comprenant au moins trois couches métalliques physiques (21, 2a, 2b, 2c, ..., 2n, 22) assemblées dans ledit guide d'ondes multicouches (1), dans lequel les couches physiques sont une couche supérieure (21), une ou plusieurs couches intermédiaires (2a, 2b, ..., 2n) et une couche inférieure (22), le guide d'ondes multicouches (1) comprend un canal de guide d'ondes (77) étant une ouverture allongée (7) dans au moins une desdites couches intermédiaires (2a, 2b, ..., 2n), dans lequel la couche intermédiaire respective (2a, 2b, ..., 2n) desdites couches physiques (21, 2a, 2b, ..., 2n, 22) présente une métasurface (3) sur une première surface (5a) faisant face à une première couche adjacente, dans lequel la métasurface (3) entoure l'ouverture allongée (7) et est une surface texturée, présentant une épaisseur de sous-longueur d'onde inférieure à la longueur d'onde divisé par 10, créé par des sections épaisses (3a) et minces (3b).

2. Guide d'ondes multicouches (1) comprenant au moins trois couches physiques (21, 2a, 2b, 2c, ..., 2n, 22) assemblées dans ledit guide d'ondes multicouches (1), dans lequel les couches physiques sont une couche supérieure (21), une ou plusieurs couches intermédiaires (2a, 2b, ..., 2n) et une couche inférieure (22), le guide d'ondes multicouches (1) comprenant un canal de guide d'ondes (77) étant une ouverture allongée (7) dans au moins une desdites couches intermédiaires (2a, 2b, ..., 2n), dans lequel au moins une desdites couches physiques (21, 2a, 2b, ..., 2n, 22) comporte une métasurface (3) sur une première surface (5a) faisant face à une première couche adjacente, dans lequel la métasurface (3) entoure l'ouverture allongée (7) et est une surface texturée, ayant une épaisseur de sous-longueur d'onde inférieure à la longueur d'onde divisée par 10, créée par des sections épaisses (3a) et minces (3b); dans lequel le guide d'ondes multicouches comprend des première (2a), deuxième (2b) et troisième (2c) couches intermédiaires, dans lequel la deuxième couche intermédiaire (2b) est une couche non texturée pour des chipsets électroniques intégrés ;
dans lequel le guide d'ondes multicouches comprend une première (2a), deuxième (2b) et troisième (2c) couches intermédiaires, comprenant chacune une ouverture allongée (7) et dans lequel la deuxième couche intermédiaire (2b) est une couche non texturée et comprend en outre un élément central (8) disposé à l'intérieur de l'ouverture allongée (7).

3. Guide d'ondes multicouches (1) comprenant au moins trois couches physiques (21, 2a, 2b, ..., 2n, 22) assemblées dans ledit guide d'ondes multicouches (1), dans lequel les couches physiques sont une couche supérieure (21), une ou plusieurs couches intermédiaires (2a, 2b, ..., 2n) et une couche inférieure (22), le guide d'ondes multicouches (1) comprend un canal de guide d'ondes (77) qui est une ouverture allongée (7) dans au moins une desdites couches intermédiaires (2a, 2b, ..., 2n), dans lequel la couche intermédiaire respective (2a, 2b, ..., 2n) desdites couches physiques (21, 2a, 2b, ..., 2n, 22) comporte une métasurface (3) sur une première surface (5a) faisant face à une première couche adjacente, dans lequel la métasurface (3) entoure la ouverture allongée (7) et est une surface texturée, ayant une épaisseur de sous-longueur d'onde inférieure à la longueur d'onde divisée par 10, créée par des sections épaisses (3a) et minces (3b), dans lequel le guide d'ondes multicouches est constitué d'un seul matériau ou le guide d'ondes multicouches est constitué de couches d'un seul matériau revêtu d'un métal.

4. Guide d'ondes multicouches (1) selon une quelconque des revendications 1 à 3, dans lequel la première surface (5a) a une partie plate (4) entourant la métasurface (3) et dans lequel les sections épaisses (3a) ont une épaisseur correspondant à l'épaisseur de couche (L1) au niveau de la partie plate (4) et les sections minces (3b) ont une épaisseur (L2) qui est inférieure à l'épaisseur au niveau de la partie plate (4) .

5. Guide d'ondes multicouches (1) selon une quelconque des revendications 1 à 4, dans lequel une seconde surface (5b) de la couche (21, 2a, 2b, ..., 2n, 22) faisant face à une seconde couche adjacente est une surface plane à l'exception de l'ouverture allongée (7) .

6. Guide d'ondes multicouches (1) selon une quelconque des revendications 1 à 5, dans lequel au moins trois couches physiques (21, 2b, 2c, ..., 2n, 22) sont des couches séparées empilées sans éléments s'étendant sur une quelconque desdites au moins trois couches physiques (21, 2a, 2b, 2c, ..., 2n, 22).

7. Guide d'ondes multicouches (1) selon une quelconque des revendications 1 à 6,
dans lequel chaque section épaisse (3a) a une quelconque des formes circulaire, elliptique, triangulaire, carrée, pentagonale, rectangulaire, rectangulaire, carrée, hexagonale ou rectangulaire.

8. Guide d'ondes multicouches selon une quelconque des revendications 1 à 7, dans lequel les sections épaisses (3a) sont disposées en rangées (6a, 6b, 6c, ..., 6n) parallèles à l'ouverture allongée (7).

9. Guide d'ondes multicouches (1) selon une quelconque des revendications 1 à 7, dans lequel les sections épaisses (3a) sont disposées à des distances irrégulières de l'ouverture allongée (7).

10. Guide d'ondes multicouches (1) selon une quelconque des revendications 1 à 9, dans lequel la différence d'épaisseur (L3) entre les sections épaisses (3a) et les sections minces (3b) de la métasurface (3) est comprise entre 50-70 % du total de ladite au moins une couche physique qui comporte la métasurface (3).

11. Guide d'ondes multicouches (1) selon une quelconque des revendications 1 à 10, dans lequel la différence d'épaisseur (L3) entre les sections épaisses (3a) et les sections minces (3b) de la métasurface (3) est inférieure à la longueur d'onde divisée par 10.

12. Guide d'ondes multicouches (1) selon une quelconque des revendications 1 à 11, dans lequel la différence d'épaisseur (L3) entre les sections épaisses (3a) et les sections minces (3b) de la métasurface (3) est inférieure à la longueur d'onde divisée par 20, de préférence inférieure à la longueur d'onde divisée par 25.

13. Guide d'ondes multicouches (1) selon une quelconque des revendications 1 à 12, dans lequel une quelconque des couches supérieure (21) et inférieure (22) comprend une métasurface (3).

14. Guide d'ondes multicouches (1) selon une quelconque des revendications 1 à 13, dans lequel le guide d'ondes multicouches (1) est implémenté sous la forme d'une antenne à guide d'ondes à fentes (40).

15. Guide d'ondes multicouches (1) selon une quelconque des revendications 1 à 14, dans lequel la couche supérieure (21) comprend des fentes d'antennes (41).

16. Procédé de production d'un guide d'ondes multicouches (1) selon une quelconque des revendications 1 à 15.
